(19) **Europäisches Patentamt**
**European Patent Office**
**Office européen des brevets**

(11) **EP 2 922 141 B1**

(12) **FASCICULE DE BREVET EUROPEEN**

(45) Date de publication et mention
de la délivrance du brevet:
**28.08.2019 Bulletin 2019/35**

(51) Int Cl.:
*H01Q 1/52* (2006.01)     *H01Q 15/14* (2006.01)
*H05K 1/02* (2006.01)     *H01Q 1/42* (2006.01)

(21) Numéro de dépôt: **15159077.5**

(22) Date de dépôt: **13.03.2015**

(54) **Dispositif de diffraction destiné à être fixé sur la face extérieure d'une paroi**

Beugungsvorrichtung zur festen Anbringung an der Außenfläche einer Wand

Diffraction device intended for being attached to the outer surface of a wall

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.03.2014 FR 1452273**

(43) Date de publication de la demande:
**23.09.2015 Bulletin 2015/39**

(73) Titulaire: **AIRBUS OPERATIONS**
**31060 Toulouse Cedex 9 (FR)**

(72) Inventeurs:
• **Thain, Andrew**
**32600 L'Isle Jourdain (FR)**

• **Jaber, Anass**
**31100 Toulouse (FR)**

(74) Mandataire: **Cabinet Le Guen Maillet**
**3, impasse de la Vigie**
**CS 71840**
**35418 Saint-Malo Cedex (FR)**

(56) Documents cités:
WO-A1-2008/127196     FR-A1- 2 983 577
FR-A1- 2 983 578     JP-A- 2012 175 422
US-A1- 2012 299 787     US-A1- 2013 293 323

**Description**

La présente invention concerne un dispositif de diffraction d'ondes électromagnétiques qui est destiné à équiper une paroi électriquement conductrice ou un mur extérieur électriquement conducteur d'un bâtiment, une paroi électriquement conductrice équipée d'un tel dispositif, ainsi qu'un bâtiment équipé d'un tel dispositif de diffraction ou d'une telle paroi équipée.

L'invention se rapporte au domaine général de la réflexion des ondes électromagnétiques, des ondes radio en particulier, et plus particulièrement à celui de la prévention des effets des ondes radioélectriques réfléchies par des structures telles que des façades de bâtiments sur l'espace environnant de telles structures. L'invention s'applique plus particulièrement en zone aéroportuaire afin d'éviter que des perturbations perturbent les systèmes de mesures radioélectriques.

A cause de la présence de nombreuses sources radioélectriques, notamment les antennes ILS elles-mêmes, le problème des réflexions parasites par les bâtiments est un problème important dont la résolution passe généralement par l'élaboration d'un plan d'implantation comportant des zones, notamment les zones relativement proches des pistes où l'on s'interdit de placer une quelconque construction de taille un tant soit peu importante. Or compte tenu, notamment, de la concentration urbaine et de la volonté de placer les zones aéroportuaires à des distances relativement faibles des zones urbaines, il devient de plus en plus nécessaire de maximiser le taux d'occupation des zones aéroportuaires en termes de surface. Par la suite, trouver une solution aux problèmes de réflexions parasites de signaux radioélectriques dans des directions sensibles apparaît plus que jamais actuel.

Le document FR-A-2 983 577 décrit un dispositif de diffraction qui comporte une pluralité d'éléments résonnants tubulaires conducteurs qui sont disposés périodiquement et de façon parallèle sur un mur extérieur d'un bâtiment.

La section de chaque élément tubulaire prend la forme d'un rectangle dont une face est fixée sur le mur extérieur du bâtiment, deux ailes, chacune solidaire d'une des extrémités de la face et perpendiculaire à la face, et de deux ailettes, chacune solidaire de l'une des ailes et parallèle à la face et dont les extrémités libres sont séparées par une fente. La capacité est alors formée par la fente.

Cette fente est orientée vers l'extérieur et est donc soumise aux intempéries. Lorsqu'il pleut, la fente et les ailettes qui la délimitent sont en contact avec l'eau. L'eau de pluie étant polarisable, la capacité du dispositif de diffraction est augmentée et son efficacité est diminuée.

Un objet de la présente invention est de proposer un dispositif de diffraction d'ondes électromagnétiques qui ne présente pas les inconvénients de l'art antérieur et qui en particulier permet d'éviter que les caractéristiques dudit dispositif soient modifiées sous l'action des éléments extérieurs tels que l'eau.

A cet effet, est proposé un dispositif de diffraction d'ondes électromagnétiques destiné à être fixé sur une face extérieure d'une paroi électriquement conductrice, le dispositif de diffraction comportant :

- une pluralité d'éléments résonnants prenant la forme d'un profilé en L qui sont électriquement conducteurs et fixés parallèlement sur la face extérieure,
- chaque élément résonnant, comportant une première paroi et une deuxième paroi solidaires perpendiculairement l'une de l'autre le long d'un bord commun, la première paroi étant destinée à être fixée perpendiculairement à la face extérieure par un bord de fixation parallèle au bord commun, tandis que le bord de la deuxième paroi qui est parallèle au bord commun constitue un bord libre, et où les bords libres de tous les éléments résonnants sont parallèles et disposés du même côté par rapport au bord commun de l'élément résonnant correspondant, et
- des moyens de protection destinés à renforcer la protection d'une zone capacitive générée dans un espace entre la face extérieure et la deuxième paroi, face à des agressions météorologiques et prenant la forme d'un panneau réalisé avec un matériau diélectrique et imperméable à l'eau, fixé à la face extérieure et recouvrant la pluralité d'éléments résonnants,
- un bloc réalisé avec un matériau diélectrique à l'eau logé entre la face extérieure et la deuxième paroi de manière à remplir le volume intérieur de l'élément résonnant en forme de L, où le matériau dudit bloc est imperméable à l'eau.

Un tel dispositif de diffraction d'ondes électromagnétiques permet donc de protéger des intempéries la capacité générée entre la face extérieure et la deuxième paroi de chacun des éléments résonnants.

La longueur de la première paroi et la longueur de la deuxième paroi de chacun des éléments résonnants du dispositif de diffraction selon l'invention sont définies en fonction d'une longueur d'onde et d'un angle d'incidence d'une onde radioélectrique incidente à diffracter.

Préférentiellement, au moins une partie dudit panneau est transparente dans le spectre visible.

Selon encore une autre variante de réalisation du dispositif de diffraction, les éléments résonnants sont en un matériau transparent dans le spectre visible.

Un deuxième objet de l'invention concerne un bâtiment comportant un mur extérieur électriquement conducteur présentant une face extérieure et un dispositif de diffraction d'ondes électromagnétiques selon l'invention où chaque élément résonnant est fixé sur ladite face extérieure.

Un troisième objet de l'invention est une paroi équipée comportant une paroi électriquement conductrice présentant une face extérieure et destinée à être fixée sur un mur extérieur d'un bâtiment et un dispositif de diffraction d'ondes électromagnétiques selon l'invention, où chaque élément résonnant est fixé sur ladite face extérieure.

Selon une variante de réalisation du troisième objet de l'invention, au moins une partie de la paroi équipée est transparente dans le spectre visible, en particulier entre 400 nm et 700 nm.

Un quatrième objet de l'invention est un bâtiment comportant un mur extérieur et une paroi équipée selon l'invention, où ladite paroi équipée est fixée sur le mur extérieur.

L'invention porte également sur un bâtiment comportant:

- un mur extérieur présentant une face extérieure et une pluralité d'ouvertures disposées horizontalement les unes à côté des autres, définissant ainsi sur la face extérieure au-dessous de l'alignement horizontal d'ouvertures, une surface inférieure et au-dessus de l'alignement horizontal d'ouvertures, une surface supérieure,
- pour chaque surface inférieure et chaque surface supérieure, un dispositif de diffraction selon l'une des variantes précédentes fixé à chaque surface inférieure et à chaque surface supérieure, et
- chaque partie de la face extérieure qui n'est pas recouverte par les dispositifs de diffraction ou percés des ouvertures est recouverte d'un revêtement absorbant les ondes radar.

L'invention porte également sur un bâtiment comportant:

- un mur extérieur présentant une face extérieure et une pluralité d'ouvertures disposées verticalement les unes au-dessus des autres, définissant ainsi sur la face extérieure à gauche de chaque alignement vertical d'ouvertures, une surface latérale gauche et à droite de chaque alignement vertical d'ouvertures, une surface latérale droite,
- pour chaque surface latérale gauche et chaque surface latérale droite, un dispositif de diffraction selon l'une des variantes précédentes fixé à chaque surface latérale gauche et chaque surface latérale droite, et
- chaque partie de la face extérieure qui n'est pas recouverte par les dispositifs de diffraction ou percés des ouvertures est recouverte d'un revêtement absorbant les ondes radar.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

la Fig. 1 est une représentation schématique d'un mur extérieur d'un bâtiment équipé d'un dispositif de diffraction d'ondes électromagnétiques,
la Fig. 2 est une représentation schématique du principe de fonctionnement d'un dispositif de diffraction d'ondes électromagnétiques,
la Fig. 3 est une représentation schématique d'un dispositif de diffraction d'ondes électromagnétiques,
la Fig. 4 est une représentation schématique d'un dispositif de diffraction d'ondes électromagnétiques selon l'invention,
la Fig. 5 est une représentation schématique d'une paroi équipée selon l'invention,
la Fig. 6 est une vue d'une partie d'un bâtiment selon un mode de réalisation particulier de l'invention, et
la Fig. 7 est une vue d'une partie d'un bâtiment selon un autre mode de réalisation particulier de l'invention.

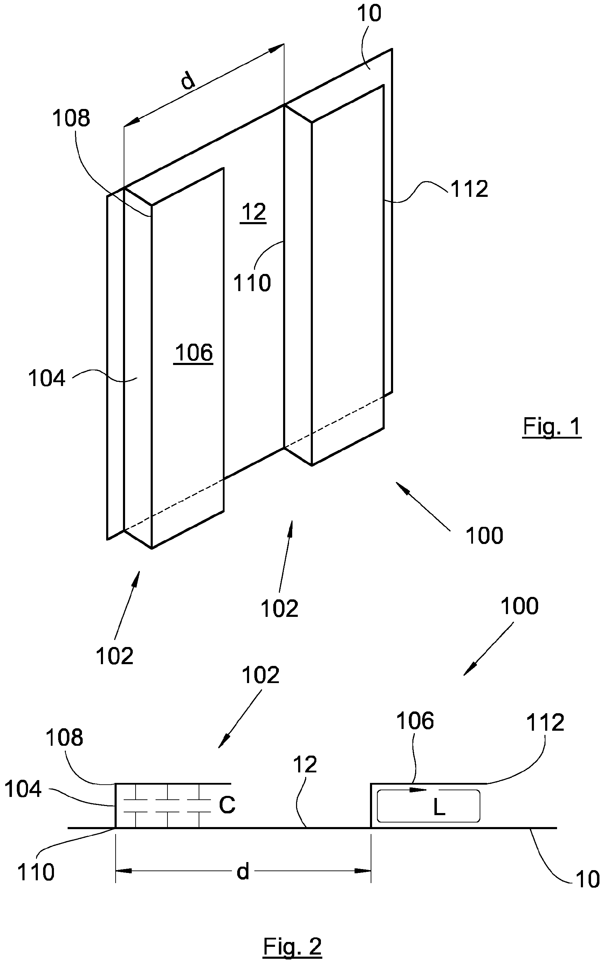

La Fig. 1 montre une paroi 10 électriquement conductrice et réflectrice qui présente une face extérieure 12 qui est orientée vers l'extérieur et sur laquelle est disposé un dispositif de diffraction d'ondes électromagnétiques 100.

La paroi 10 peut être électriquement conductrice du fait du matériau la constituant ou du fait de l'application d'un revêtement électriquement conducteur (par exemple une peinture) sur elle.

Le dispositif de diffraction 100 comporte une pluralité d'éléments résonnants 102 qui sont fixés de manière périodique et parallèlement les uns aux autres sur la face extérieure 12 et dont la longueur dépend des dimensions de la face extérieure 12 à recouvrir.

Chaque élément résonnant 102 est réalisé dans un matériau électriquement conducteur et prend la forme d'un profilé en L.

Préférentiellement, chaque élément résonnant 102 est réalisé en Aluconbond ® qui est fabriqué par la société 3A Composites et qui est constitué d'une bande de plastique prise en sandwich entre deux feuilles d'aluminium.

Les éléments résonnants 102 sont agencés sur la face extérieure 12 de façon à former un réseau de diffraction présentant un pas 'd' qui est déterminé en fonction de la longueur d'onde λ et de l'angle d'incidence 0 des ondes électromagnétiques incidentes de façon à créer un réseau de diffraction réalisant un déphasage de l'onde réfléchie selon une direction spéculaire.

Selon que la source de l'émission radioélectrique reçue par la face extérieure 12 est considérée comme une source lointaine ou non, le pas 'd est constant ou varie en fonction de l'angle d'incidence local de l'onde électromagnétique.

L'élément résonnant 102 comporte une première paroi 104 et une deuxième paroi 106 qui sont solidaires perpendiculairement l'une de l'autre le long d'un bord commun 108. La première paroi 104 et la deuxième paroi 106 sont ici rectangulaires.

La première paroi 104 est fixée perpendiculairement à la face extérieure 12 par un bord de fixation 110 distinct et parallèle au bord commun 108.

Le bord de la deuxième paroi 106 qui est distinct et parallèle au bord commun 108 constitue un bord libre 112.

Ainsi, la première paroi 104 est perpendiculaire à la face extérieure 12 et la deuxième paroi 106 est parallèle à la face extérieure 12.

Tous les éléments résonnants 102 sont orientés dans le même sens, c'est-à-dire que tous les bords libres 112 sont parallèles et disposés du même côté par rapport au bord commun 108 de l'élément résonnant 102 correspondant.

Les éléments résonnants 102 sont agencés sur la face extérieure 12 de façon à être orientés dans une direction sensiblement perpendiculaire au plan défini par les vecteurs de propagation des ondes incidente et réfléchie. Ainsi, dans le cas précis d'un mur extérieur de bâtiment, les éléments résonnants 102 sont disposés verticalement.

La Fig. 2 montre le principe de fonctionnement de l'invention. Chaque élément résonnant 102 forme un circuit résonnance R - inductance L - capacité C.

La partie gauche de la Fig. 2 montre que la capacité C est générée dans un espace entre la face extérieure 12 et la deuxième paroi 106. Cet espace est appelé zone capacitive et la capacité ainsi créée à l'intérieur de l'élément résonnant 102 est éloignée de la pluie.

La partie droite de la Fig. 2 montre que l'inductance L est formée par la première paroi 104, la deuxième paroi 106 et la face extérieure 12 et est fonction de l'aire intérieure du profilé en forme de L.

Les dimensions des éléments résonnants 102 sont déterminées de manière à ce que les valeurs de l'inductance L et de la capacité C permettent de réaliser un circuit équivalent résonnant ayant une fréquence de résonnance $F_0$ et une bande passante $\Delta F_0$ définies par les relations:

$$F_0 = \frac{1}{2\pi}\frac{1}{\sqrt{LC}},$$

et

$$\frac{\Delta F}{F_0} = \frac{1}{R}\sqrt{\frac{L}{C}}.$$

Chaque élément résonnant 102 est dimensionné, de manière à ce que lorsqu'il est éclairé par une onde radioélectrique incidente issue d'une source d'émission selon une direction d'incidence, l'élément résonnant 102 produit une onde radioélectrique de même fréquence mais affectée d'un déphasage donné, de sorte que les ondes réfléchies par les différents éléments résonnants 102 et les ondes directement réfléchies par des portions de la face extérieure 12 situées entre ces éléments résonnants 102 s'annulent dans la direction spéculaire. L'intégralité de l'onde radio électrique incidente est ainsi réfléchie vers la source d'émission selon la direction d'incidence.

En outre, une telle construction entraîne que la valeur de la capacité est moins sensible aux imperfections de fabrication que dans le cas du dispositif de diffraction de l'état de la technique.

En outre, la quantité de matériau conducteur qui est utilisée est moindre que dans le cas du dispositif de diffraction de l'état de la technique, et les éléments résonnants 102 sont particulièrement faciles à mettre en place sans qu'il soit nécessaire de prévoir des renforcements structurels. De plus, cette réduction de quantité de matériau conducteur permet également de réduire le coût du dispositif.

La longueur de la première paroi 104 et la longueur de la deuxième paroi 106 sont définies en fonction de la longueur d'onde et de l'angle d'incidence de l'onde radioélectrique incidente à diffracter.

Selon un mode de réalisation particulier, le signal émis par une antenne d'un système d'atterrissage ILS est diffracté lorsque la longueur de la deuxième paroi 106 est de l'ordre de 60 cm $\pm$ 4 mm. Une telle tolérance est supérieure à la tolérance admise dans le cas du dispositif de diffraction de l'état de la technique.

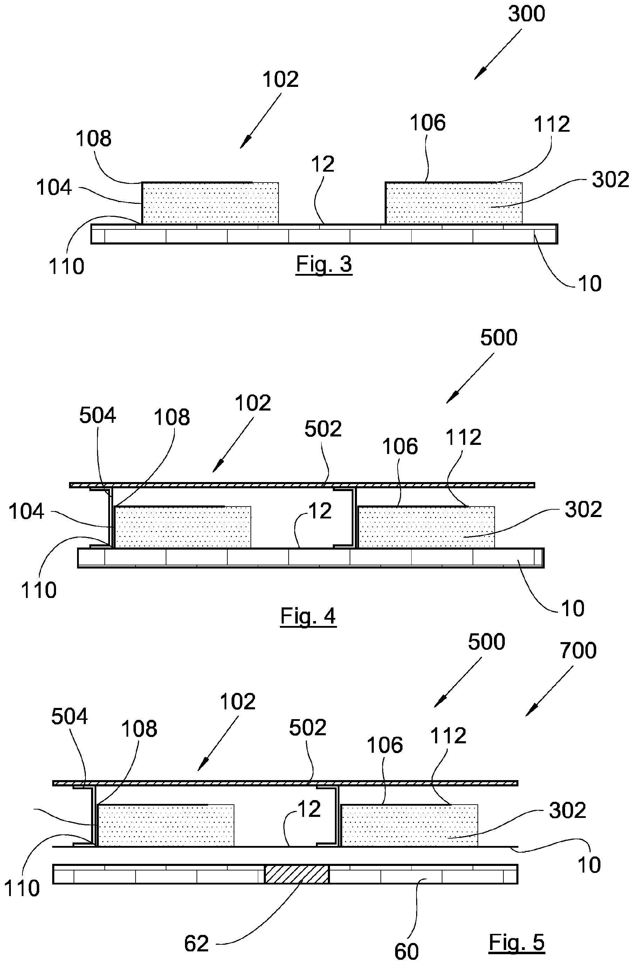

Plus particulièrement, dans le cas des Figs. 3 et 4, la paroi 10 est le mur extérieur électriquement conducteur d'un bâtiment, par exemple un hangar réalisé en plaque métallique ou une paroi recouverte d'un revêtement électriquement conducteur, mais la paroi 10 peut être également une paroi additionnelle fixée sur un mur extérieur d'un bâtiment.

La Fig. 3 montre un dispositif de diffraction 300 d'ondes électromagnétiques.

Si le support de la paroi 10 ne permet pas de supporter le dispositif de diffraction 100, un bloc 302 est logé entre la face extérieure 12 et la deuxième paroi 106 de manière à remplir le volume intérieur du L. Le bloc 302 est réalisé avec un matériau diélectrique et imperméable à l'eau, comme par exemple du polystyrène extrudé.

Bien sûr, la présence du bloc 302 doit être prise en compte pour déterminer les longueurs de la première paroi 104 et de la deuxième paroi 106.

La Fig. 4 montre un dispositif de diffraction 500 d'ondes électromagnétiques selon l'invention qui est basé sur les dispositifs de diffraction 100 et 300.

Sur la Fig. 4, le dispositif de diffraction 500 comporte des moyens de protection destinés à renforcer la protection de la face de la deuxième paroi 106 qui est orientée vers l'extérieur, c'est-à-dire de l'autre côté de la deuxième paroi 106 par rapport à la face extérieure 12, face à des agressions météorologiques. Cette face est appelée la face agressée.

Les moyens de protection renforcent ainsi la protection de la zone capacitive générée dans l'espace entre la face extérieure 12 et la deuxième paroi 106.

Bien sûr, la présence des moyens de protection doit être prise en compte pour déterminer les longueurs de la première paroi 104 et de la deuxième paroi 106.

Dans le cas de la Fig. 4, les moyens de protection prennent la forme d'un panneau 502 fixé à la face extérieure 12 et recouvrant la pluralité d'éléments résonnants 102. Le panneau 502 est réalisé avec un matériau diélectrique et imperméable à l'eau.

Le maintien du panneau 502 est assuré ici par la mise en place d'entretoises 504 qui prennent ici la forme de profilés en C, et qui sont fixées entre la face extérieure 12 et le panneau 502. Chaque entretoise 504 est placée à côté d'une première paroi 104.

Les entretoises 504 peuvent être réalisées dans un matériau diélectrique ou un matériau électriquement conducteur.

Dans le cas où la visibilité à travers le panneau 502 doit être assurée, par exemple lorsqu'une fenêtre est présente, au moins une partie du panneau 502, en particulier la partie en regard de la fenêtre, et plus particulièrement tout le panneau 502, est choisi de manière à être transparent dans le spectre visible.

De la même manière, si la visibilité à travers un élément résonnant 102, les moyens de protection, un bloc 302 doit être assurée, chacun de ces éléments est choisi de manière à être transparent dans le spectre visible, en particulier entre 400 nm et 700 nm.

Dans le cas de la Fig. 5, la paroi 10 est une paroi additionnelle électriquement conductrice et fixée sur la façade extérieure d'un mur extérieur 60 d'un bâtiment par tous moyens appropriés, par exemple lorsque ledit mur extérieur 60 n'est pas électriquement conducteur ou lorsque son état de surface est granuleux.

La Fig. 5 montre ainsi une paroi équipée 700 selon l'invention, qui comporte la paroi additionnelle 10 électriquement conductrice sur la face extérieure 12 de laquelle les éléments résonnants 102 sont fixés.

Lorsque le bâtiment présente des fenêtres 62, au moins une partie de la paroi additionnelle 10 est transparente dans le spectre visible, en particulier les parties de la paroi additionnelle 10 qui sont en regard des fenêtres 62.

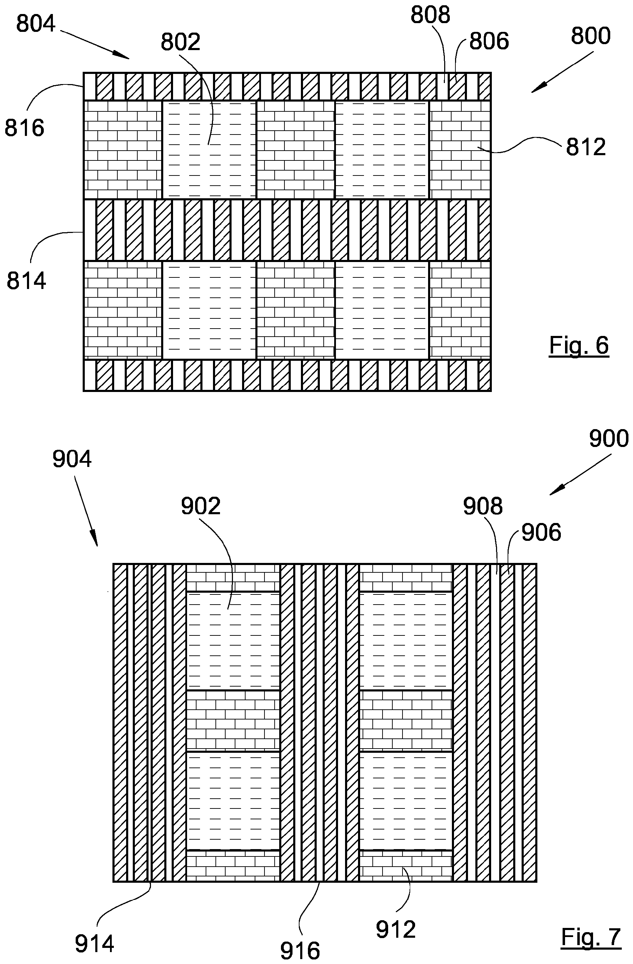

La Fig. 6 montre une partie 800 de la face extérieure 812 d'un mur extérieur d'un bâtiment qui comporte des ouvertures 802 (ici au nombre de 4). Les ouvertures 802 sont disposées horizontalement les unes à côté des autres. Il est ainsi défini sur la face extérieure 812 au-dessous de chaque alignement horizontal d'ouvertures 802, une surface inférieure 814 et au-dessus de chaque alignement horizontal d'ouvertures 802, une surface supérieure 816.

Bien sûr lorsqu'il y a des ouvertures disposées verticalement les unes au-dessus des autres, la surface inférieure 814 d'un alignement horizontal devient la surface supérieure de l'alignement horizontal juste au-dessous.

Un dispositif de diffraction 804 est fixé à chaque surface inférieure 814 et à chaque surface supérieure 816.

Chaque dispositif de diffraction 804 est conforme à celui décrit précédemment sous la référence 500 et chaque élément résonnant s'étend verticalement, et sur la Fig. 6, chaque dispositif de diffraction 804 prend la forme d'un dispositif de diffraction 100.

Chaque partie hachurée 806 constitue une deuxième paroi 106 et chaque partie non-hachurée 808 constitue un espace entre deux dispositifs de diffraction 804 consécutifs.

Chaque partie de la face extérieure 812 qui n'est pas recouverte par les dispositifs de diffraction 804 ou percés des ouvertures 802 est recouverte d'un revêtement absorbant les ondes radar (en Anglais: "Radar absorbant materials" RAM), tels que des matériaux constitués de mousses chargées en carbone et céramiques.

La Fig. 7 montre une partie 900 de la face extérieure 912 d'un mur extérieur d'un bâtiment qui comporte des ouvertures 902 (ici au nombre de 4). Les ouvertures 902 sont disposées verticalement les unes au-dessus des autres. Il est ainsi défini sur la face extérieure 912 à gauche de chaque alignement vertical d'ouvertures 902, une surface latérale gauche 914 et à droite de chaque alignement vertical d'ouvertures 902, une surface latérale droite 916.

Bien sûr lorsqu'il y a des ouvertures disposées horizontalement les unes à côté des autres, la surface latérale gauche 914 d'un alignement vertical devient la surface latérale droite de l'alignement vertical juste à droite.

Un dispositif de diffraction 904 est fixé à chaque surface latérale gauche 914 et à chaque surface latérale droite 916.

Chaque dispositif de diffraction 904 est conforme à celui décrit précédemment sous la référence 500 et chaque élément résonnant s'étend verticalement, et sur la Fig. 7, chaque dispositif de diffraction 904 prend la forme d'un dispositif de diffraction 100.

Chaque partie hachurée 906 constitue une deuxième paroi 106 et chaque partie non-hachurée 908 constitue un espace entre deux dispositifs de diffraction 904 consécutifs.

Chaque partie de la face extérieure 912 qui n'est pas recouverte par les dispositifs de diffraction 904 ou percés des ouvertures 902 est recouverte d'un revêtement absorbant les ondes radar (en Anglais: "Radar absorbant materials" RAM), tels que des matériaux constitués de mousses chargées en carbone et céramiques.

**Revendications**

1. Dispositif de diffraction (500) d'ondes électromagnétiques destiné à être fixé sur une face extérieure (12) d'une paroi (10) électriquement conductrice, le dispositif de diffraction (500) comportant :

- une pluralité d'éléments résonnants (102) prenant la forme d'un profilé en L qui sont électriquement conducteurs et fixés parallèlement sur la face extérieure (12),

- chaque élément résonnant (102), comportant une première paroi (104) et une deuxième paroi (106) solidaires perpendiculairement l'une de l'autre le long d'un bord commun (108), la première paroi (104) étant destinée à être fixée perpendiculairement à la face extérieure (12) par un bord de fixation (110) parallèle au bord commun (108), tandis que le bord de la deuxième paroi (106) qui est parallèle au bord commun (108) constitue un bord libre (112), le dispositif de diffraction (500) étant **caractérisé en ce que**:

- un bloc (302) réalisé avec un matériau diélectrique est logé entre la face extérieure (12) et la deuxième paroi (106) de manière à remplir le volume intérieur de l'élément résonnant en forme de L, **en ce que**

- les bords libres (112) de tous les éléments résonnants (102) sont parallèles et disposés du même côté par rapport au bord commun (108) de l'élément résonnant (102) correspondant, **en ce que**

- le dispositif de diffraction comporte en outre des moyens de protection destinés à renforcer la protection d'une zone capacitive générée dans un espace entre la face extérieure (12) et la deuxième paroi (106), face-'à des agressions météorologiques et prenant la forme d'un panneau (502) réalisé avec un matériau diélectrique et imperméable à l'eau, fixé à la face extérieure (12) et recouvrant la pluralité d'éléments résonnants (102), et

**en ce que** le matériau dudit bloc (302) est imperméable à l'eau.

2. Dispositif de diffraction (500) selon la revendication 1, **caractérisé en ce que** la longueur de la première paroi (104) et la longueur de la deuxième paroi (106) sont définies en fonction d'une longueur d'onde et d'un angle d'incidence d'une onde radioélectrique incidente à diffracter.

3. Dispositif de diffraction (500) selon l'une des revendications 1 ou 2, **caractérisé en ce qu'**au moins une partie dudit panneau (502) est transparente dans le spectre visible.

4. Dispositif de diffraction (500) selon l'une quelconque des revendications précédentes, **caractérisé en ce que** les éléments résonnants sont en un matériau transparent dans le spectre visible.

5. Bâtiment comportant un mur extérieur électriquement conducteur présentant une face extérieure (12) et un dispositif de diffraction (500) d'ondes électromagnétiques selon une des revendications 1 à 4, où chaque élément résonnant (102) est fixé sur ladite face extérieure (12).

6. Paroi équipée (700) comportant :

- une paroi (10) électriquement conductrice présentant une face extérieure (12) et destinée à être fixée sur un mur extérieur (60) d'un bâtiment, et

- un dispositif de diffraction (500) d'ondes électromagnétiques selon une des revendications 1 à 4, où chaque élément résonnant (102) est fixé sur ladite face extérieure (12).

7. Paroi équipée (700) selon la revendication 6, **caractérisée en ce qu'**au moins une partie de la paroi (10) est transparente dans le spectre visible.

8. Bâtiment comportant un mur extérieur et une paroi équipée (700) selon une des revendications 6 ou 7, où ladite paroi équipée (700) est fixée sur le mur extérieur.

9. Bâtiment comportant:

- un mur extérieur présentant une face extérieure (812) et une pluralité d'ouvertures (802) disposées horizontalement les unes à côté des autres, définissant ainsi sur la face extérieure (812) au-dessous de l'alignement horizontal d'ouvertures (802), une surface inférieure (814) et au-dessus de l'alignement horizontal d'ouvertures (802), une surface supérieure (816),

- pour chaque surface inférieure (814) et chaque surface supérieure (816), un dispositif de diffraction (804) selon l'une des revendications 1 à 4 fixé à chaque surface inférieure (814) et à chaque surface supérieure (816), et

- chaque partie de la face extérieure (812) qui n'est pas recouverte par les dispositifs de diffraction (804) ou percés des ouvertures (802) est recouverte d'un revêtement absorbant les ondes radar.

10. Bâtiment comportant:

- un mur extérieur présentant une face extérieure (912) et une pluralité d'ouvertures (902) disposées verticalement les unes au-dessus des autres, définissant ainsi sur la face extérieure (912) à gauche de chaque alignement vertical d'ouvertures (902), une surface latérale gauche (914) et à droite de chaque alignement vertical d'ouvertures (902), une surface latérale droite (916),

- pour chaque surface latérale gauche (914) et chaque surface latérale droite (916), un dispositif de diffraction (904) selon l'une des revendications 1 à 4 fixé à chaque surface latérale gauche (914) et chaque surface latérale droite (916), et

- chaque partie de la face extérieure (912) qui n'est pas recouverte par les dispositifs de diffraction (904) ou percés des ouvertures (902) est recouverte d'un revêtement absorbant les ondes radar.

**Patentansprüche**

1. Beugungsvorrichtung (500) elektromagnetischer Wellen, die dazu bestimmt ist, an einer Außenseite (12) einer elektrisch leitenden Wand (10) befestigt zu werden, wobei die Beugungsvorrichtung (500) aufweist:

  - eine Vielzahl von Resonanzelementen (102), die die Form eines L-förmigen Profilteils annehmen, die elektrisch leitend und parallel an der Außenseite (12) befestigt sind,
  - wobei jedes Resonanzelement (102) eine erste Wand (104) und eine zweite Wand (106) aufweist, die lotrecht zueinander entlang eines gemeinsamen Rands (108) fest miteinander verbunden sind, wobei die erste Wand (104) dazu bestimmt ist, durch einen Befestigungsrand (110) parallel zum gemeinsamen Rand (108) lotrecht an der Außenseite (12) befestigt zu werden, während der Rand der zweiten Wand (106), der parallel zum gemeinsamen Rand (108) ist, einen freien Rand (112) bildet,

  wobei die Beugungsvorrichtung (500) **dadurch gekennzeichnet ist, dass**:

  - ein aus einem dielektrischen Material hergestellter Block (302) zwischen der Außenseite (12) und der zweiten Wand (106) untergebracht wird, um das Innenvolumen des L-förmigen Resonanzelements zu füllen, dass
  - die freien Ränder (112) aller Resonanzelemente (102) parallel und auf der gleichen Seite bezüglich des gemeinsamen Rands (108) des entsprechenden Resonanzelements (102) angeordnet sind, dass
  - die Beugungsvorrichtung außerdem Schutzeinrichtungen aufweist, die dazu bestimmt sind, den Schutz einer kapazitiven Zone, die in einem Raum zwischen der Außenseite (12) und der zweiten Wand (106) erzeugt wird, gegenüber Wettereinflüssen zu verstärken und die Form einer Platte (502) annehmen, die aus einem dielektrischen und wasserfesten Material hergestellt, an der Außenseite (12) befestigt ist und die Vielzahl von Resonanzelementen (102) bedeckt, und

  - dass das Material des Blocks (302) wasserfest ist.

2. Beugungsvorrichtung (500) nach Anspruch 1, **dadurch gekennzeichnet, dass** die Länge der ersten Wand (104) und die Länge der zweiten Wand (106) abhängig von einer Wellenlänge und von einem Einfallwinkel einer zu beugenden Funkwelle definiert werden.

3. Beugungsvorrichtung (500) nach einem der Ansprüche 1 oder 2, **dadurch gekennzeichnet, dass** mindestens ein Teil der Platte (502) im sichtbaren Spektrum transparent ist.

4. Beugungsvorrichtung (500) nach einem der vorhergehenden Ansprüche, **dadurch gekennzeichnet, dass** die Resonanzelemente aus einem im sichtbaren Spektrum transparenten Material sind.

5. Gebäude, das eine elektrisch leitende Außenmauer aufweist, die eine Außenseite (12) und eine Beugungsvorrichtung (500) elektromagnetischer Wellen nach einem der Ansprüche 1 bis 4 aufweist, wobei jedes Resonanzelement (102) an der Außenseite (12) befestigt ist.

6. Bestückte Wand (700), die aufweist:

  - eine elektrisch leitende Wand (10), die eine Außenseite (12) aufweist und dazu bestimmt ist, an einer Außenmauer (60) eines Gebäudes befestigt zu werden, und
  - eine Beugungsvorrichtung (500) elektromagnetischer Wellen nach einem der Ansprüche 1 bis 4, wobei jedes Resonanzelement (102) an der Außenseite (12) befestigt ist.

7. Bestückte Wand (700) nach Anspruch 6, **dadurch gekennzeichnet, dass** mindestens ein Teil der Wand (10) im sichtbaren Spektrum transparent ist.

8. Gebäude, das eine Außenmauer und eine bestückte Wand (700) nach einem der Ansprüche 6 oder 7 aufweist, wobei die bestückte Wand (700) an der Außenmauer befestigt ist.

9. Gebäude, das aufweist:

  - eine Außenmauer, die eine Außenseite (812) und eine Vielzahl von Öffnungen (802) aufweist, die waagrecht nebeneinander angeordnet sind, wodurch an der Außenseite (812) unter der waagrechten Anordnung von Öffnungen (802) eine untere Fläche (814) und über der waagrechten Anordnung von Öffnungen (802) eine obere Fläche (816) definiert werden,
- für jede untere Fläche (814) und jede obere Fläche (816) eine Beugungsvorrichtung (804) nach einem der Ansprüche 1 bis 4, die an jeder unteren Fläche (814) und an jeder oberen Fläche (816) befestigt ist, und
- jeder Teil der Außenseite (812), der nicht von den Beugungsvorrichtungen (804) bedeckt oder mit den Öffnungen (802) versehen ist, mit einer die Radarwellen absorbierenden Verkleidung bedeckt ist.

10. Gebäude, das aufweist:

- eine Außenmauer, die eine Außenseite (912) und eine Vielzahl von Öffnungen (902) aufweist, die senkrecht übereinander angeordnet sind, wodurch an der Außenseite (912) links von jeder senkrechten Anordnung von Öffnungen (902) eine linke Seitenfläche (914) und rechts von jeder senkrechten Anordnung von Öffnungen (902) eine rechte Seitenfläche (916) definiert wird,
- für jede linke Seitenfläche (914) und jede rechte Seitenfläche (916) eine Beugungsvorrichtung (904) nach einem der Ansprüche 1 bis 4, die an jeder linken Seitenfläche (914) und jeder rechten Seitenfläche (916) befestigt ist, und
- jeder Teil der Außenseite (912), der nicht von den Beugungsvorrichtungen (904) bedeckt wird oder mit den Öffnungen (902) versehen ist, mit einer die Radarwellen absorbierenden Verkleidung bedeckt ist.

**Claims**

1. Electromagnetic wave diffraction device (500) intended to be fixed onto an outer face (12) of an electrically conductive wall (10), the diffraction device (500) comprising:

    - a plurality of resonant elements (102) in the form of an L-shaped profile which are electrically conductive and fixed parallel on the outer face (12),
    - each resonant element (102), comprising a first wall (104) and a second wall (106) secured at right angles to one another along a common edge (108), the first wall (104) being intended to be fixed at right angles to the outer face (12) by a fixing edge (110) parallel to the common edge (108), whereas the edge of the second wall (106) which is parallel to the common edge (108) constitutes a free edge (112)

the diffraction device (500) being **characterized in that** a block (302) produced with a dielectric material is housed between the outer face (12) and the second wall (106) so as to fill the internal volume of the L-shaped resonant element, **in that** the free edges (112) of all the resonant elements (102) are parallel and arranged on the same side relative to the common edge (108) of the corresponding resonant element (102), **in that** the diffraction device (500) comprises also protection means intended to reinforce the protection of a capacitive area generated in a space between the outer face (12) and the second wall (106), against weather attack, and taking the form of a panel (502) produced with a dielectric material that is impermeable to water, fixed to the outer face (12) and covering the plurality of resonant elements (102), and **in that** the material of said block (302) is impermeable to water.

2. Diffraction device (500) according to Claims 1, **characterized in that** the length of the first wall (104) and the length of the second wall (106) are defined as a function of a wavelength and of an angle of incidence of an incident radiofrequency wave to be diffracted.

3. Diffraction device (500) according to one of Claims 1 or 2, **characterized in that** at least a part of said panel (502) is transparent in the visible spectrum.

4. Diffraction device (500) according to any one of the preceding claims, **characterized in that** the resonant elements are made of a material that is transparent in the visible spectrum.

5. Building comprising an electrically conductive outer wall having an outer face (12) and an electromagnetic wave diffraction device (500) according to one of Claims 1 to 4, in which each resonant element (102) is fixed onto said outer face (12).

6. Equipped wall (700) comprising:

    - an electrically conductive wall (10) having an outer face (12) and intended to be fixed onto an outer wall (60) of a building, and
    - an electromagnetic wave diffraction device (500) according to one of Claims 1 to 4, in which each resonant element (102) is fixed onto said outer face (12).

7. Equipped wall (700) according to Claim 6, **characterized in that** at least a part of the wall (10) is transparent in the visible spectrum.

8. Building comprising an outer wall and an equipped wall (700) according to one of Claims 6 or 7, in which said equipped wall (700) is fixed onto the outer wall.

9. Building comprising:

- an outer wall having an outer face (812) and a plurality of apertures (802) arranged horizontally to one another, thus defining, on the outer face (812) below the horizontal alignment of apertures (802), a lower surface (814) and, above the horizontal alignment of apertures (802), an upper surface (816),
- for each lower surface (814) and each upper surface (816), a diffraction device (804) according to one of Claims 1 to 4 fixed to each lower surface (814) and to each upper surface (816), and
- each part of the outer face (812) which is not covered by the diffraction devices (804) or pierced with the apertures (802) is covered with a coating absorbing the radar waves.

10. Building comprising:

- an outer wall having an outer face (912) and a plurality of apertures (902) arranged vertically to one another, thus defining, on the outer face (912) to the left of each vertical alignment of apertures (902), a left lateral surface (914) and, to the right of each vertical alignment of apertures (902), a right lateral surface (916),
- for each left lateral surface (914) and each right lateral surface (916), a diffraction device (904) according to one of Claims 1 to 4 fixed to each left lateral surface (914) and each right lateral surface (916), and
- each part of the outer face (912) which is not covered by the diffraction devices (904) or pierced with the apertures (902) is covered with a coating absorbing the radar waves.

Fig. 1

Fig. 2

Fig. 3

Fig. 4

Fig. 5

804  802  808  806  800

816  812

814

_Fig. 6_

904  902  908  900  906

914  916  912

_Fig. 7_

**RÉFÉRENCES CITÉES DANS LA DESCRIPTION**

**Documents brevets cités dans la description**

- FR 2983577 A